# EUROPEAN PATENT APPLICATION

(11) **EP 4 362 332 A1**
(43) Date of publication of application: **01.05.2024**
(21) Application number: 21955527.3
(22) Date of filing: 03.09.2021
(51) Int. Cl.: H03H 9/19, H03H 9/15, H03H 9/10

(54) **CRYSTAL OSCILLATOR PLATE, CRYSTAL OSCILLATOR, AND ELECTRONIC DEVICE**

(71) Applicant: Huawei Technologies Co., Ltd., Longgang Shenzhen, Guangdong 518129 (CN)
(72) Inventor: YANG, Lei, Shenzhen, Guangdong 518129 (CN); YAN, Hang, Shenzhen, Guangdong 518129 (CN); LUO, Haifeng, Shenzhen, Guangdong 518129 (CN); ZHANG, Zhenlong, Shenzhen, Guangdong 518129 (CN)
(74) Representative: Huawei European IPR
(86) International application number: PCT/CN2021/116464
(87) International publication number: WO 2023/028993

(57) **Abstract**

This application provides a crystal oscillating wafer, a crystal oscillator, and an electronic device. The crystal oscillating wafer is a sheet in a symmetric shape. A symmetry axis of the crystal oscillating waferhas at least a first point and a second point. A distance from the first point to a first endpoint on the symmetry axis is less than a distance from the second point to the first endpoint. A width that is of the crystal oscillating wafer in a first direction and that passes the first point is greater than a width that is of the crystal oscillating wafer in the first direction and that passes the second point. The first direction is a direction perpendicular to the symmetry axis on a surface of the crystal oscillating wafer. The crystal oscillating wafer includes an oscillation region. The oscillation region includes a first concave region located on an upper surface and a second concave region located on a lower surface of the crystal oscillating wafer. The crystal oscillating wafer has a stronger capability of resisting an external stress wave.

## Description

### TECHNICAL FIELD

This application relates to the field of crystal devices, and more specifically, to a crystal oscillating wafer, a crystal oscillator, and an electronic device.

### BACKGROUND

With rapid development of technologies, electronic products evolve toward miniaturization, high rates, and large capacities, and a requirement on crystal oscillators widely used in the electronic products becomes increasingly high. A relationship between a thickness of a crystal oscillating wafer and an oscillation frequency of the crystal oscillating wafer is that the oscillation frequency=1.66/thickness. It can be seen that the oscillation frequency of the crystal oscillating wafer is inversely proportional to the thickness of the crystal oscillating wafer. A higher oscillation frequency indicates a smaller thickness of the crystal oscillating wafer. For example, for a crystal oscillating wafer with a fundamental frequency of 16.6 MHz, a thickness is 0.1 mm, and for a crystal oscillating wafer with a high fundamental frequency of greater than 250 MHz, a thickness is less than 6.68 um. However, the thickness of the crystal oscillating wafer affects a capability of the crystal oscillating wafer to resist an external stress wave. When the crystal oscillating wafer is used in a clock chip, a crystal oscillating wafer with a poor capability of resisting an external stress wave causes deterioration of a phase noise indicator of a clock. In addition, because different substances have different coefficients of thermal expansion, when an external temperature changes, stress is generated among a printed circuit board (printed circuit board, PCB), a solder, and various electronic components on the PCB. If the crystal oscillating wafer has a poor capability of resisting an external stress wave, output of the crystal oscillator is affected, resulting in system exceptions. A structure of an existing crystal oscillating wafer has a poor capability of resisting an external stress wave. Therefore, a crystal oscillating wafer with a strong capability of resisting an external stress wave is urgently needed.

### SUMMARY

This application provides a crystal oscillating wafer, a crystal oscillator, and an electronic device. The crystal oscillating wafer has a strong capability of resisting an external stress wave.

According to a first aspect, a crystal oscillating wafer is provided. The crystal oscillating wafer is a sheet in a symmetric shape. A symmetry axis of the crystal oscillating wafer has at least a first point and a second point. A distance from the first point to a first endpoint on the symmetry axis is less than a distance from the second point to the first endpoint. A width that is of the crystal oscillating wafer in a first direction and that passes the first point is greater than a width that is of the crystal oscillating wafer in the first direction and that passes the second point. The first direction is a direction perpendicular to the symmetry axis on a surface of the crystal oscillating wafer. The crystal oscillating wafer includes an oscillation region. The oscillation region includes a first concave region located on an upper surface and a second concave region located on a lower surface of the crystal oscillating wafer.

Therefore, in this application, the crystal oscillating wafer provided in this application is in the symmetric shape, and the crystal oscillating wafer is different from an existing square crystal oscillating wafer. The width of the crystal oscillating wafer provided in this application is not a fixed value. Under a same condition, the crystal oscillating wafer provided in this application has a stronger capability of resisting an external stress wave.

With reference to the first aspect, in some implementations of the first aspect, the crystal oscillating wafer is an isosceles trapezoidal sheet. A first side that is of the crystal oscillating wafer and that passes the first endpoint is a lower base of the crystal oscillating wafer.

With reference to the first aspect, in some implementations of the first aspect, a shape of the crystal oscillating wafer is a hexagonal sheet formed by a first square region and an isosceles trapezoidal region. A second side of the first square region coincides with a lower base of the isosceles trapezoidal region. The second side is an opposite side of a first side that is of the crystal oscillating wafer and that passes the first endpoint.

With reference to the first aspect, in some implementations of the first aspect, the crystal oscillating wafer is an octagonal sheet formed by a second square region and a third square region. A part of a third side of the second square region coincides with a fourth side of the third square region. A midpoint of the third side coincides with a midpoint of the fourth side. The third side is longer than the fourth side, and the third side is an opposite side of a first side that is of the crystal oscillating wafer and that passes the first endpoint.

With reference to the first aspect, in some implementations of the first aspect, a shape of the crystal oscillating wafer is a pentagonal sheet formed by a fourth square region and an isosceles triangular region. A fifth side of the fourth square region coincides with a base of the isosceles triangular region. The fifth side is an opposite side of a first side that is of the crystal oscillating wafer and that passes the first endpoint.

With reference to the first aspect, in some implementations of the first aspect, a distance from the oscillation region to the first endpoint is less than a distance from the oscillation region to a second endpoint of the symmetry axis.

Therefore, in this application, the distance from the oscillation region to the first endpoint may be short, so that the capability of the crystal oscillating wafer to resist the external stress wave can be further improved.

With reference to the first aspect, in some implementations of the first aspect, first glue dispensing and second glue dispensing are provided on the first side that is of the crystal oscillating wafer and that passes the first endpoint, and distances from the first glue dispensing and the second glue dispensing to the first endpoint are equal.

With reference to the first aspect, in some implementations of the first aspect, third glue dispensing is provided on the second endpoint of the symmetry axis.

Therefore, in this application, the symmetric first glue dispensing and second glue dispensing may be provided on the first side of the crystal oscillating wafer, so that the capability of the crystal oscillating wafer to resist the external stress wave can be further improved.

According to a second aspect, a crystal oscillator is provided, and the crystal oscillator may include the crystal oscillating wafer according to any implementation of the first aspect.

According to a third aspect, an electronic device is provided. The electronic device may include the crystal oscillator according to the second aspect.

### BRIEF DESCRIPTION OF DRAWINGS

FIG. 1 shows a schematic circuit diagram of a negative-resistance crystal oscillator;
FIG. 2 shows a schematic top view of a rectangular crystal oscillating wafer 200;
FIG. 3 shows a diagram of a spectral response characteristic of a crystal oscillating wafer 200;
FIG. 4 shows a schematic top view of another rectangular crystal oscillating wafer 400;
FIG. 5 shows a diagram of a spectral response characteristic of a crystal oscillating wafer 400;
FIG. 6 shows a schematic top view of a pentagonal crystal oscillating wafer 600;
FIG. 7 shows a diagram of a spectral response characteristic of a crystal oscillating wafer 600;
FIG. 8 shows a schematic top view of an isosceles trapezoidal crystal oscillating wafer 800 according to an embodiment of this application;
FIG. 9 shows a schematic top view of a hexagonal crystal oscillating wafer 900 according to an embodiment of this application;
FIG. 10 shows a schematic top view of an octagonal crystal oscillating wafer 1000 according to an embodiment of this application;
FIG. 11 shows a schematic top view of a pentagonal crystal oscillating wafer 1100 according to an embodiment of this application;
FIG. 12 shows a schematic sectional view of a crystal oscillating wafer according to an embodiment of this application;
FIG. 13 shows a diagram of spectral response comparison between a crystal oscillating wafer provided in embodiments of this application and an existing crystal oscillating wafer;
FIG. 14 shows a schematic diagram of a structure of a crystal oscillator 10 according to an embodiment of this application; and
FIG. 15 shows a schematic diagram of a structure of an electronic device 20 according to an embodiment of this application.

### DESCRIPTION OF EMBODIMENTS

The following describes technical solutions of this application with reference to accompanying drawings.

In this embodiment of this application, a crystal oscillating wafer may also be referred to as a chip, and is a sheet made of a crystal material, for example, a quartz crystal. The quartz crystal is a silicon dioxide crystal with piezoelectric effect. If an electric field is applied to two electrodes of the quartz crystal, the crystal oscillating wafer is mechanically deformed. On the contrary, if mechanical pressure is applied on two sides of the crystal oscillating wafer, an electric field is generated in a corresponding direction of the crystal oscillating wafer. This physical phenomenon is referred to as the piezoelectric effect. This effect is reversible. If an alternating voltage is applied to two poles of the crystal oscillating wafer, the crystal oscillating wafer generates mechanical oscillation, and the mechanical oscillation of the crystal oscillating wafer further generates an alternating field.

A crystal oscillator, which is also a crystal oscillator for short, is made by using the piezoelectric effect of the crystal oscillating wafer. Two corresponding surfaces of the crystal oscillating wafer are coated with electrode materials to be electrodes. Each electrode is welded with a lead connected to a pin of a driver integrated circuit. Then, a package housing is added to form the crystal oscillator. The crystal oscillator may usually be packaged with a metal housing, a glass housing, ceramics, or plastic.

The crystal oscillator may provide stable and accurate single-frequency oscillation in a resonance state by using a characteristic of conversion between crystal electric energy and mechanical energy. Usually, an amplitude of the mechanical oscillation and an amplitude of the alternating field of the crystal oscillating wafer are excessively small. However, when a frequency of the external alternating voltage is a specific value, the amplitude is clearly increased, and is much greater than an amplitude at another frequency. This phenomenon is referred to as piezoelectric resonance. The specific frequency may also be referred to as an oscillation frequency of the crystal oscillating wafer, or a fundamental frequency, or a fundamental frequency for short.

The crystal oscillating wafer and the crystal oscillator provided in embodiments of this application may be used in various electronic devices, for example, user equipment, an access terminal, a subscriber unit, a subscriber station, a mobile station, a mobile console, a remote station, a remote terminal, a mobile device, a user terminal, a terminal, a wireless communication device, a user agent, or a user apparatus. A terminal device may alternatively be a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a computing device, another processing device connected to a wireless modem, a vehicle-mounted device, a wearable device, another electronic device including a clock circuit, or the like. This is not limited in embodiments of this application.

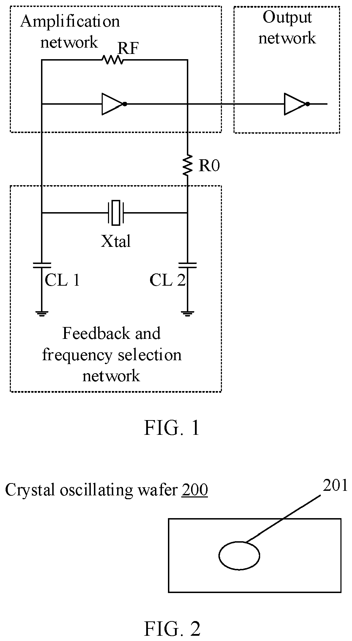

The crystal oscillator may include an oscillation circuit. From a perspective of a characteristic of an active device in the oscillation circuit and a principle of forming oscillation, the crystal oscillator may be classified into two types: a feedback type and a negative resistance type. A feedback-type oscillation circuit is an oscillation circuit formed by connecting a positive feedback network and the active device, and a negative-resistance-type oscillation circuit is an oscillation circuit formed by directly connecting a two-terminal active device presenting a negative resistance characteristic to a resonant circuit. For ease of understanding embodiments of this application, a schematic diagram of a circuit of a negative-resistance-type crystal oscillator according to an embodiment of this application is first described in detail with reference to FIG. 1. The circuit mainly includes an amplification network, an output network, and a feedback and frequency selection network. The amplification network may include a phase inverter and a resistor RF connected in parallel to the phase inverter. The amplification network is configured to amplify power, works in a linear region of the phase inverter in an oscillation start-up phase, and works in a non-linear phase in a stabilization phase. The feedback and frequency selection network selects each frequency signal of an amplifier by using a capacitor CL 1 and a capacitor CL 2 that are connected to a crystal Xtal, and feeds back the frequency signal to input of the amplifier. It should be noted that FIG. 1 merely describes an example of the crystal oscillator in which a crystal oscillating wafer provided in an embodiment of this application is used, and does not constitute any limitation on this application.

With rapid development of technologies, electronic products continuously evolve toward miniaturization, a high rate, and a large capacity, and a requirement for a crystal oscillator that is widely used in the electronic product is increasingly high. A relationship between a thickness of a crystal oscillating wafer and an oscillation frequency of the crystal oscillating wafer is as follows: Oscillation frequency=1.66/Thickness. It can be seen that the oscillation frequency of the crystal oscillating wafer is inversely proportional to the thickness of the crystal oscillating wafer. A higher oscillation frequency indicates a smaller thickness of the crystal oscillating wafer. For example, for a crystal oscillating wafer with a fundamental frequency of 16.6 MHz, a thickness is 0.1 mm, and for a crystal oscillating wafer with a high fundamental frequency of more than 250 MHz, a thickness is less than 6.68 um. However, the thickness of the crystal oscillating wafer affects a capability of the crystal oscillating wafer to resist an external stress wave. When the crystal oscillating wafer is used in a clock chip, a crystal oscillating wafer with a poor capability of resisting the external stress wave causes deterioration of a clock phase noise indicator. In addition, because different substances have different thermal expansion coefficients, a change of an external temperature may cause mismatch among thermal expansion coefficients of components on a PCB on which the crystal oscillator is located. As a result, stress is generated among the PCB, solder, and the electronic components on the PCB board. If the crystal oscillator has a poor capability of resisting the external stress wave, after the stress accumulates to an extent and is released in an instant, output of the crystal oscillator is affected, and a system consequently works abnormally.

The capability of the crystal oscillating wafer to resist the external stress wave may be reflected by a quantity of resonance points of the crystal oscillator in a frequency range and a response amplification coefficient corresponding to the resonance point. It is found through research that a smaller quantity of resonance points in a frequency range indicates a smaller response amplification coefficient corresponding to the resonance point, and a stronger capability of the crystal oscillating wafer to resist the external stress wave. A spectrum response characteristic curve may be obtained by using a test circuit, and may reflect a difference between amplification capabilities of the crystal oscillating wafer for signals at different frequencies. A horizontal coordinate of the spectrum response characteristic curve is a frequency, and a unit is usually kHz. A vertical coordinate is a response amplification coefficient corresponding to the frequency, and a unit is usually dB. Therefore, the quantity of resonance points and the response amplification coefficient corresponding to the resonance point may be seen from the spectrum response characteristic curve, to learn the capability of the crystal oscillating wafer to resist the external stress wave.

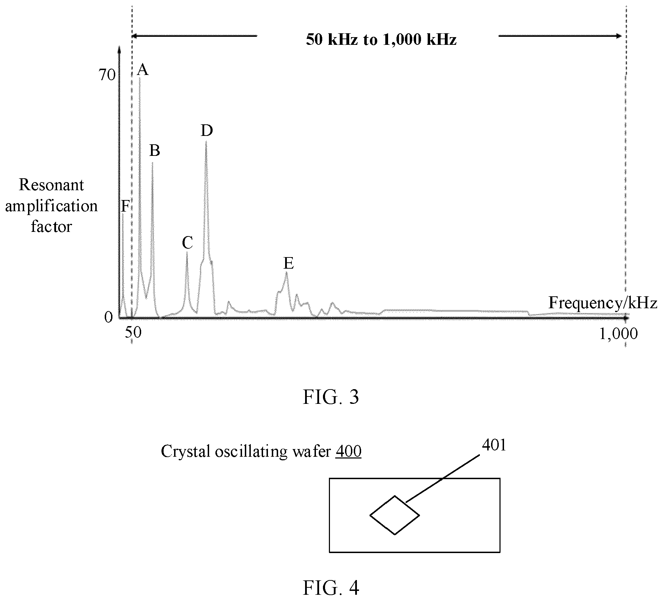

Currently, there are mainly three structures of the crystal oscillating wafer, and the following respectively describes the three structures. FIG. 2 shows a top view of a crystal oscillating wafer 200. The crystal oscillating wafer 200 is a rectangular sheet, and an elliptical oscillation region 201 is provided in the middle of the crystal oscillating wafer 200. In addition, an upper surface electrode (not shown in the figure) and a lower surface electrode (not shown in the figure) are respectively disposed on an upper surface and a lower surface of the oscillation region 201. A voltage is separately applied to the upper surface electrode and the lower surface electrode, so that a voltage difference is formed between the upper surface electrode and the lower surface electrode, to obtain a response amplification coefficient corresponding to 50 kHz to 1000 kHz. FIG. 3 shows a diagram of a spectrum response characteristic of the crystal oscillator chip. It can be seen from FIG. 3 that the crystal oscillator includes five resonance points between 50 kHz and 1000 kHz.

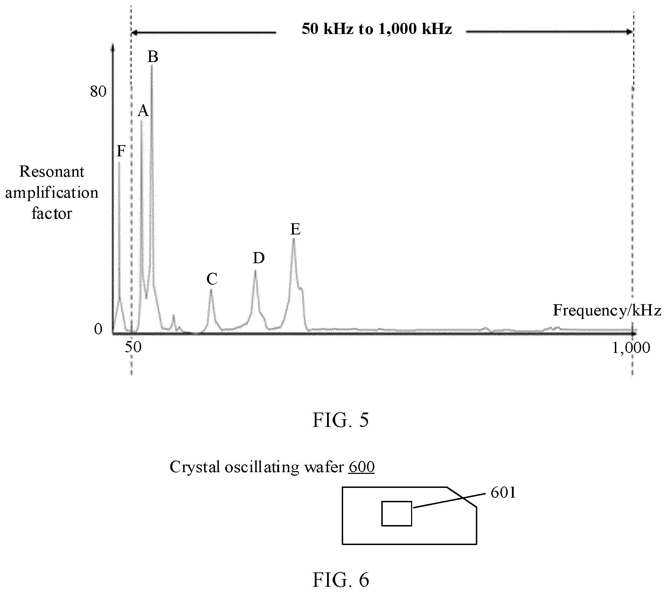

FIG. 4 shows a top view of another crystal oscillating wafer 400. The crystal oscillating wafer is a rectangular sheet, and a diamond-shaped oscillation region 401 is provided in the middle of the crystal oscillating wafer 400. An upper surface electrode (not shown in the figure) and a lower surface electrode (not shown in the figure) are respectively disposed on an upper surface and a lower surface of the oscillation region 401. A voltage is separately applied to the upper surface electrode and the lower surface electrode, so that a voltage difference is formed between the upper surface electrode and the lower surface electrode, to obtain a response amplification coefficient corresponding to 50 kHz to 1000 kHz. FIG. 5 shows a diagram of a spectrum response characteristic of the crystal oscillating wafer. It can be seen from FIG. 5 that the crystal oscillator also includes five resonance points between 50 kHz and 1000 kHz.

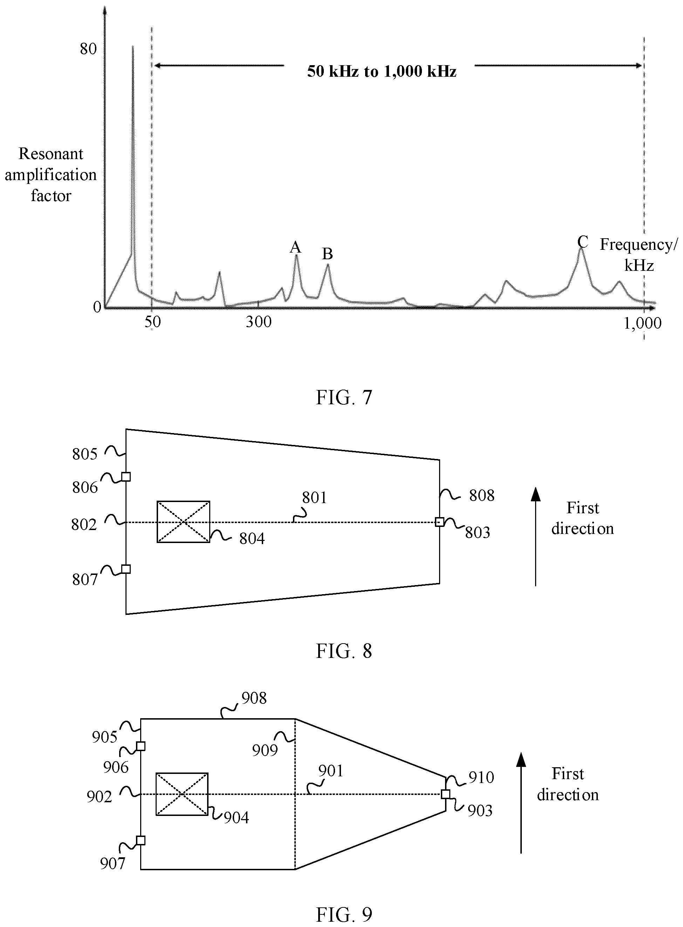

FIG. 6 shows a top view of still another crystal oscillating wafer 600. The crystal oscillating wafer is a pentagonal sheet, a square oscillation region 601 is provided in the middle of the crystal oscillating wafer 600. An upper surface electrode (not shown in the figure) and a lower surface electrode (not shown in the figure) are respectively disposed on an upper surface and a lower surface of the square oscillation region 601. A voltage is separately applied to the upper surface electrode and the lower surface electrode, so that a voltage difference is formed between the upper surface electrode and the lower surface electrode, to obtain a response amplification coefficient corresponding to 50 kHz to 1000 kHz. FIG. 7 shows a diagram of a spectrum response characteristic of the crystal oscillating wafer. It can be seen from FIG. 7 that the crystal oscillator includes three resonance points between 50 kHz and 1000 kHz.

It can be seen from FIG. 2 to FIG. 7 that an existing crystal oscillating wafer has a poor capability of resisting an external stress wave. Therefore, a crystal oscillating wafer with a strong capability of resisting the external stress wave is urgently needed.

This application provides a crystal oscillating wafer. The crystal oscillating wafer is a sheet in a symmetric shape. A symmetry axis of the crystal oscillating wafer has at least a first point and a second point. A distance from the first point to a first endpoint on the symmetry axis is less than a distance from the second point to the first endpoint. A width that is of the crystal oscillating wafer in a first direction and that passes the first point is greater than a width that is of the crystal oscillating wafer in the first direction and that passes the second point. The first direction is a direction perpendicular to the symmetry axis on a surface of the crystal oscillating wafer. The crystal oscillating wafer includes an oscillation region. The oscillation region includes a first concave region located on an upper surface and a second concave region located on a lower surface.

Optionally, projections of the first concave region and the second concave region on the upper surface or the lower surface of the crystal oscillating wafer approximately overlap. For ease of understanding embodiments of this application, the following provides detailed descriptions with reference to FIG. 8 to FIG. 11. It should be noted that, for clarity, the following uses a square oscillation region as an example, without constituting any limitation on this application. FIG. 8 shows a top view of an isosceles trapezoidal crystal oscillating wafer 800. A first side that is of the crystal oscillating wafer and that passes a first endpoint is a lower base of the crystal oscillating wafer. The following is described with reference to reference numerals in the figure: 801: symmetry axis of the crystal oscillating wafer; 802: first endpoint of the symmetry axis 801; 803: second endpoint of the symmetry axis 801, and third glue dispensing; 804: oscillation region; 805: first side (that is, lower base of an isosceles trapezoid) passing the first endpoint; 806: first glue dispensing; 807: second glue dispensing; 808: opposite side (that is, upper base of the isosceles trapezoid) of the first side.

As an example rather than a limitation, a length of the upper base (808) of the crystal oscillating wafer may be less than or equal to 2 mm, a length of the lower base (805) may be less than or equal to 2 mm, and a height (801) is less than or equal to 3 mm. In addition, a side length of the oscillation region (804) may be less than or equal to 1 mm, and a distance from a center point of the oscillation region (804) to the lower base (805) of the crystal oscillating wafer may be less than or equal to 2.5 mm. Distances from the first glue dispensing (806) and the second glue dispensing (807) to the first endpoint (802) may be less than or equal to 1 mm.

FIG. 9 shows a top view of a hexagonal crystal oscillating wafer 900. A shape of the crystal oscillating wafer is a hexagonal sheet formed by a first square region and an isosceles trapezoidal region. A second side of the first square region coincides with a lower base of the isosceles trapezoidal region. The second side is an opposite side of a first side that is of the crystal oscillating wafer and that passes a first endpoint. The following is described with reference to reference numerals in the figure: 901: symmetry axis of the crystal oscillating wafer; 902: first endpoint of the symmetry axis 901; 903: second endpoint of the symmetry axis 901, and third glue dispensing; 904: oscillation region; 905: first side passing the first endpoint; 906: first glue dispensing; 907: second glue dispensing; 908: adjacent side of the first side; 909: second side, and lower base of the isosceles trapezoidal region; 910: upper base of the isosceles trapezoidal region.

As an example rather than a limitation, a length of the first side (905) of the square region is less than or equal to 2 mm, a length of the adjacent side (908) of the first side is less than or equal to 3 mm, a length of the upper base (910) of the isosceles trapezoidal region is less than or equal to 2 mm, and a length of a height of the isosceles trapezoidal region is less than or equal to 3 mm. In addition, a side length of the oscillation region (904) may be less than or equal to 1 mm, and a distance from a center point of the oscillation region (904) to the first side (905) may be less than or equal to 2.5 mm. Distances from the first glue dispensing (906) and the second glue dispensing (907) to the first endpoint (902) may be less than or equal to 1 mm.

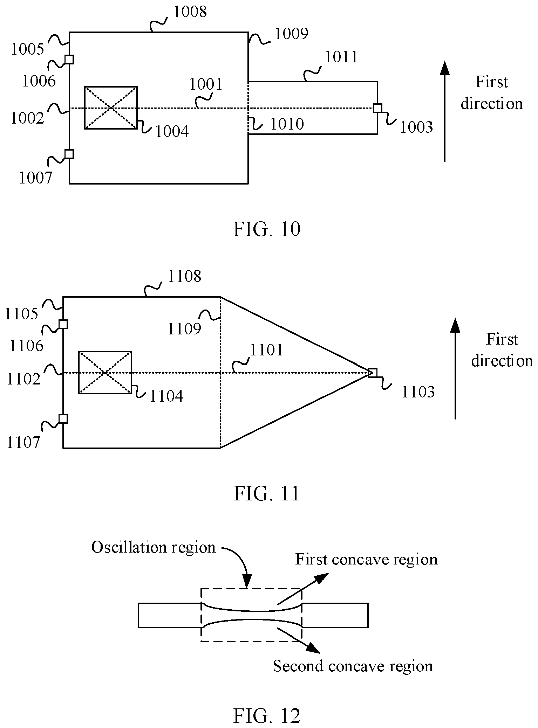

FIG. 10 shows a top view of an octagonal crystal oscillating wafer 1000. The crystal oscillating wafer is an octagonal sheet formed by a second square region and a third square region. A part of a third side of the second square region coincides with a fourth side of the third square region. A midpoint of the third side coincides with a midpoint of the fourth side. The third side is longer than the fourth side. The third side is an opposite side of a first side that is of the crystal oscillating wafer and that passes a first endpoint. The following is described with reference to reference numerals in the figure: 1001: symmetry axis of the crystal oscillating wafer; 1002: first endpoint of the symmetry axis 1001; 1003: second endpoint of the symmetry axis 1001, and third glue dispensing; 1004: oscillation region; 1005: first side passing the first endpoint; 1006: first glue dispensing; 1007: second glue dispensing; 1008: adjacent side of the first side; 1009: third side; 1010: fourth side; 1011: adjacent side of the fourth side.

As an example rather than a limitation, lengths of the first side (1005) and the third side (1009) of the second square region are less than or equal to 2 mm, a length of the adjacent side (1008) of the first side is less than or equal to 3 mm, a length of the fourth side (1010) of the third square region is less than or equal to 2 mm, and a length of the adjacent side 1011 of the fourth side is less than or equal to 3 mm. In addition, a side length of the oscillation region (1004) may be less than or equal to 1 mm, and a distance from a center point of the oscillation region (1004) to the first side (1005) may be less than or equal to 2.5 mm. Distances from the first glue dispensing (1006) and the second glue dispensing (1007) to the first endpoint (1002) may be less than or equal to 1 mm.

FIG. 11 shows a top view of another pentagonal crystal oscillating wafer 1100. A shape of the crystal oscillating wafer is a pentagonal sheet formed by a fourth square region and an isosceles triangular region. A fifth side of the fourth square region coincides with a base of the isosceles triangular region. The fifth side is an opposite side of a first side that is of the crystal oscillating wafer and that passes a first endpoint. The following is described with reference to reference numerals in the figure: 1101: symmetry axis of the crystal oscillating wafer; 1102: first endpoint of the symmetry axis 1001; 1103: second endpoint of the symmetry axis 1001, and third glue dispensing; 1104: oscillation region; 1105: first side passing the first endpoint; 1106: first glue dispensing; 1107: second glue dispensing; 1108: adjacent side of the first side; 1109: fifth side (lower base of the isosceles triangular region).

As an example rather than a limitation, lengths of the first side (1105) and the fifth side (1109) of the fourth square region are less than or equal to 2 mm, a length of the adjacent side (1108) of the first side is less than or equal to 3 mm, and a height of the isosceles triangular region is less than or equal to 3 mm. In addition, a side length of the oscillation region (1104) may be less than or equal to 1 mm, and a distance from a center point of the oscillation region (1104) to the first side (1105) may be less than or equal to 2.5 mm. Distances from the first glue dispensing (1106) and the second glue dispensing (1107) to the first endpoint (1102) may be less than or equal to 1 mm.

The foregoing describes the shapes and sizes of the crystal oscillating wafer by using examples. The crystal oscillating wafer may be a silicon dioxide sheet, and a thickness of the crystal oscillating wafer may be determined based on a frequency required by an application.

FIG. 12 shows a sectional view of a crystal oscillating wafer according to an embodiment of this application. A section is perpendicular to an upper surface of the crystal oscillating wafer, and includes an oscillation region. Projections of a first concave region and a second concave region on the upper surface or a lower surface of the crystal oscillating wafer approximately overlap. It should be noted that FIG. 12 is merely an example of the first concave region and the second concave region, and does not constitute any limitation on shapes of sections of the first concave region and the second concave region. For example, the first concave region and the second concave region may be concave regions formed by etching the crystal oscillating wafer.

Optionally, a first electrode is disposed in the first concave region, and a second electrode is disposed in the second concave region. In other words, the first electrode is disposed on an upper surface of the oscillation region, and the second electrode is disposed on a lower surface of the oscillation region. Materials of the first electrode and the second electrode may be conductive materials such as silver, copper, or gold. This is not particularly limited in this application. A voltage is separately applied to the first electrode and the second electrode, so that a voltage difference is formed between the upper surface and the lower surface of the oscillation region. The crystal oscillating wafer generates mechanical oscillation due to a piezoelectric effect of a material of the crystal oscillating wafer.

The oscillation region may alternatively be a square, a circle (including an ellipse), or a diamond. The oscillation region may alternatively be symmetric with respect to a symmetry axis of the crystal oscillating wafer. In a possible implementation, a distance from the oscillation region to a first endpoint is less than a distance from the oscillation region to a second endpoint of the symmetry axis. In other words, a distance from a center point of the oscillation region to the first endpoint is less than a distance from the center point of the oscillation region to the second endpoint of the symmetry axis.

In a possible implementation, first glue dispensing and second glue dispensing are provided on a first side that is of the crystal oscillating wafer and that passes the first endpoint. A distance from the first glue dispensing to the first endpoint is equal to a distance from the second glue dispensing to the first endpoint. The first electrode is connected to the first glue dispensing through a wire, and the second electrode is connected to the second glue dispensing through a wire. It should be noted that the first glue dispensing and the second glue dispensing may use conductive metal glue, and the first electrode and the second electrode may obtain the voltage through the first glue dispensing and the second glue dispensing. In other words, the first glue dispensing and the second glue dispensing may not only be used to fasten the crystal oscillating wafer, but also be used to conduct electricity.

In a possible implementation, third glue dispensing is provided on the second endpoint of the symmetry axis. The third glue dispensing is used to fasten the crystal oscillating wafer, for example, fasten the crystal oscillating wafer on a base.

In addition, it should be noted that, performing glue dispensing on the crystal oscillating wafer to obtain the first glue dispensing may mean respectively performing glue dispensing twice on an upper surface and a lower surface that are of the crystal oscillating wafer and that are at a first glue dispensing position to obtain the first glue dispensing. Similarly, performing glue dispensing on the crystal oscillating wafer to obtain the second glue dispensing may mean respectively performing glue dispensing twice on an upper surface and a lower surface that are of the crystal oscillating wafer and that are at a second glue dispensing position to obtain the second glue dispensing. Therefore, the first glue dispensing, the second glue dispensing, and the third glue dispensing described above may also be collectively referred to as five-point glue dispensing.

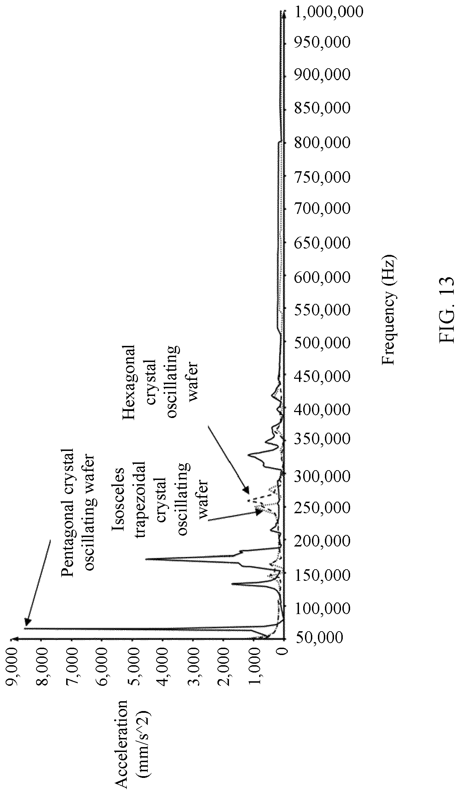

Through simulation and experiments, it can be learned that the crystal oscillating wafer provided in embodiments of this application has a strong capability of resisting an external stress. FIG. 13 shows a diagram of spectrum response comparison between a crystal oscillator provided in embodiments of this application and an existing crystal oscillator. Refer to FIG. 13. Same excitation is separately applied to a crystal oscillator that uses the pentagonal crystal oscillating wafer shown in FIG. 6, a crystal oscillator that uses the isosceles trapezoidal crystal oscillating wafer shown in FIG. 8, and a crystal oscillator that uses the hexagonal crystal oscillating wafer shown in FIG. 9, and acceleration responses at 0 kHz to 1000 kHz are measured in the oscillation regions of the three crystal oscillating wafers, to obtain a schematic diagram of a spectrum response. It should be noted that areas of the three types of crystal oscillating wafers are approximately the same, and locations and areas of the oscillation regions are also approximately the same. It can be learned from FIG. 13 that, in comparison with the existing pentagonal crystal oscillating wafer, acceleration response peak values of the isosceles trapezoidal crystal oscillating wafer and the hexagonal crystal oscillating wafer provided in embodiments of this application are reduced by approximately sevenfold, and performance is clearly optimized in a frequency range from 50 kHz to 1000 kHz.

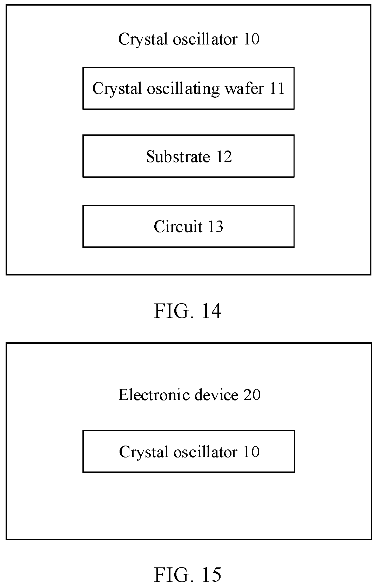

FIG. 14 shows a crystal oscillator 10 according to an embodiment of this application. The crystal oscillator 10 includes a crystal oscillating wafer 11, and the crystal oscillating wafer 11 may include the crystal oscillating wafers in the foregoing embodiments of this application. Optionally, the crystal oscillator 10 may further include a base 12. The crystal oscillating wafer 11 may be connected to the base 12 by using glue dispensing on the crystal oscillating wafer. Optionally, the crystal oscillator 10 may further include a circuit 13. The circuit 13 may be the oscillation circuit described above. This is not particularly limited in this application.

FIG. 15 shows an electronic device 20 according to an embodiment of this application. The electronic device 20 includes the crystal oscillator 10 shown in FIG. 14. The electronic device may be an electronic device that needs to use the crystal oscillator, such as a computer main board or a controller.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

It should be understood that, in embodiments of this application, numbers "first", "second", and the like are merely for distinguishing between different objects, for example, to distinguish between different network devices, and do not constitute a limitation on the scope of embodiments of this application. Embodiments of this application are not limited thereto.

It should be further understood that, in this application, "when" and "if" mean that a network element performs corresponding processing in an objective situation, and are not intended to limit time. The terms do not mean that the network element is required to have a determining action during implementation, and do not mean any other limitation.

It should be further understood that in embodiments of this application, "B corresponding to A" indicates that B is associated with A, and B may be determined based on A. However, it should be further understood that, determining B based on A does not mean that B is determined only based on A, and B may alternatively be determined based on A and/or other information.

It should also be understood that the term "and/or" in this specification describes only an association relationship for describing associated objects and represents that three relationships may exist. For example, A and/or B may represent the following three cases: Only A exists, both A and B exist, and only B exists. In addition, a character "/" in this specification usually indicates an "or" relationship between contextually associated objects.

Unless otherwise specified, an expression in this application similar to an expression that "an item includes one or more of the following: A, B, and C" usually means that the item may be any one of the following cases: A; B; C; A and B; A and C; B and C; A, B, and C; A and A; A, A, and A; A, A, and B; A, A, and C; A, B, and B; A, C, and C; B and B; B, B and B; B, B and C; C and C; C, C, and C; and another combination of A, B and C. In the foregoing descriptions, three elements A, B, and C are used as an example to describe an optional case of the item. When an expression is "the item includes at least one of the following: A, B, ..., and X", in other words, more elements are included in the expression, a case to which the item is applicable may also be obtained according to the foregoing rule.

It may be understood that various numbers in embodiments of this application are merely used for differentiation for ease of description, and are not used to limit the scope of embodiments of this application. Sequence numbers of the foregoing processes do not mean execution sequences. The execution sequences of the processes should be determined based on functions and internal logic of the processes.

## Claims

1. A crystal oscillating wafer, wherein the crystal oscillating wafer is in a symmetric shape, a symmetry axis of the crystal oscillating wafer has at least a first point and a second point, a distance from the first point to a first endpoint on the symmetry axis is less than a distance from the second point to the first endpoint, a width that is of the crystal oscillating wafer in a first direction and thatand that passes the first point is greater than a width that is of the crystal oscillating wafer in the first direction and that passes the second point, and the first direction is a direction perpendicular to the symmetry axis on an upper surface of the crystal oscillating wafer, wherein
the crystal oscillating wafer comprises an oscillation region, and the oscillation region comprises a first concave region located on the upper surface and a second concave region located on a lower surface of the crystal oscillating wafer.

2. The crystal oscillating wafer according to claim 1, wherein the crystal oscillating wafer is an isosceles trapezoidal sheet, and a first side that is of the crystal oscillating wafer and that passes the first endpoint is a lower base of the crystal oscillating wafer.

3. The crystal oscillating wafer according to claim 1, wherein a shape of the crystal oscillating wafer is a hexagonal sheet formed by a first square region and an isosceles trapezoidal region, a second side of the first square region coincides with a lower base of the isosceles trapezoidal region, and the second side is an opposite side of a first side that is of the crystal oscillating wafer and that passes the first endpoint.

4. The crystal oscillating wafer according to claim 1, wherein the crystal oscillating wafer is an octagonal sheet formed by a second square region and a third square region, a part of a third side of the second square region coincides with a fourth side of the third square region, a midpoint of the third side coincides with a midpoint of the fourth side, the third side is longer than the fourth side, and the third side is an opposite side of a first side that is of the crystal oscillating wafer and that passes the first endpoint.

5. The crystal oscillating wafer according to claim 1, wherein a shape of the crystal oscillating wafer is a pentagonal sheet formed by a fourth square region and an isosceles triangular region, a fifth side of the fourth square region coincides with a base of the isosceles triangular region, and the fifth side is an opposite side of a first side that is of the crystal oscillating wafer and that passes the first endpoint.

6. The crystal oscillating wafer according to any one of claims 1 to 5, wherein a distance from the oscillation region to the first endpoint is less than a distance from the oscillation region to a second endpoint of the symmetry axis.

7. The crystal oscillating wafer according to any one of claims 1 to 6, wherein first glue dispensing and second glue dispensing are provided on the first side that is of the crystal oscillating wafer and that passes the first endpoint, and distances from the first glue dispensing and the second dispensing glue to the first endpoint are equal.

8. The crystal oscillating waferaccording to any one of claims 1 to 7, wherein third glue dispensing is providedon the second endpoint of the symmetry axis.

9. A crystal oscillator, wherein the crystal oscillator comprises the crystal oscillating wafer according to any one of claims 1 to 8, an oscillation circuit, and a base, the crystal oscillating wafer and the oscillation circuit are located on the base, and the crystal oscillating wafer is electrically connected to the oscillation circuit.

10. An electronic device, wherein the electronic device comprises the crystal oscillator according to claim 9.
